**Europäisches Patentamt**

**European Patent Office**

**Office européen des brevets**

(19)

(11) **EP 1 519 198 A1**

(12) **EUROPEAN PATENT APPLICATION**

(43) Date of publication:
**30.03.2005 Bulletin 2005/13**

(51) Int Cl.$^7$: **G01R 31/02**

(21) Application number: **03425631.3**

(22) Date of filing: **29.09.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK**<br><br>(71) Applicants:<br>• **CNX S.p.A.**<br>  **20126 Milano (IT)**<br>• **Siemens Aktiengesellschaft**<br>  **80333 München (DE)** | (72) Inventors:<br>• **Ricchiuti, Vittorio**<br>  **67100 L'Aquila (IT)**<br>• **Antonini, Giulio**<br>  **67051 Avezzano (IT)**<br>• **Orlandi, Antonio**<br>  **00191 Roma (IT)**<br><br>(74) Representative: **Giustini, Delio**<br>**Siemens Mobile Communications S.p.A,**<br>**Palazzo Gorky**<br>**Via Monfalcone, 1**<br>**20092 Cinisello Balsamo (IT)** |

(54) **A method and test bench for evaluating the transfer impedance (Zt) and the transfer admittance (Yt) of shielded cables**

(57)     The present invention relates to a method and specific test bench arrangement for measuring the screening effectiveness of cables by the evaluation of the transfer impedance (Zt) and the transfer admittance (Yt).

The currents injected in the external screen of cables and the corresponding longitudinal voltages induced in the conductors are, first of all, measured, then a very accurate estimation of Zt and Yt is obtained through the claimed model, starting from an initial approximate value of them, by imposing a good match between the measured and the calculated values of the induced voltages.

In the model the coupling between the shield current and the internal conductors is modeled by concentrating the distributed voltage and current sources in lumped voltage and current generators at one end of the line, considering the remaining part as a simple passive transmission line (TL).

**FIG. 4**

**Description**

**Field of the invention**

The present invention relates to a testing method and specific test bench arrangement for electrical measuring.
More particularly, the invention relates to a method and specific test bench arrangement for evaluating the screening effectiveness of cables by the measurement of the transfer impedance (Zt) and the transfer admittance (Yt).

**Background art**

Because of the continue increase in bandwidth demand and the introduction of more and more stringent electromagnetic compatibility (EMC) and electromagnetic interference (EMI) standards, shielding effectiveness is becoming one of the most relevant requirements for the design of new telecommunication equipments.
The conventional definition of shielding effectiveness is a ratio of two field quantities: the incident threat energy and the energy absorbed in the contents of a shielded enclosure.
The energy absorbed in the contents of a shielded enclosure based on absorbing materials, is related to the incident threat energy. Such a relationship would indicate the efficiency of the shielded enclosure.
In telecommunication equipments, the shielding effectiveness is strictly related to the amount of electromagnetic noise that is injected or radiate through the cables connected to the equipment itself.
In order to reduce the electromagnetic noise, conductors of shielded cables are surrounded by one or more conductive screen (e.g. coaxial RF-cables and twin-ax cables). The cables contribution to the shielding effectiveness of the equipments is determined only by the quality of such screen.
The quality of the screen can be evaluated by the measurement of the transfer impedance (Zt) which is defined as the quotient of the longitudinal voltage induced in the outer circuit (environment) respect to the current in the inner circuit (cable) or vice versa, per unit length.

$$Z_t = \frac{U_2}{I_1 \cdot L}$$

The shielding is effective to the extent that currents induced in the screen are ineffective in generating disturbances in the inner conductors.
To obtain a good feeling about the EMC/EMI performances of the cables, the values of the transfer impedance (Zt) and the transfer admittance (Yt) have to be evaluated at any frequency of interest.
Usually transfer impedance and transfer admittance are measured by the cable manufacturer, who provides the nominal value of Zt and Yt.
Nevertheless cables are subjected to handling, storing and transportation, consequently further measurements are required to obtain the actual values of Zt and Yt.
In the prior art there are two basic main measurement methods for evaluating the transfer impedance and admittance of a shielded cable: the triaxial method and the line injection method.
The two methods require a high technical background, suitable measurement instruments and a lot of measurement time.
Details about the techniques used for transfer impedance and admittance measurements can be found in:

- P. Degauque, J Hamelin: "Electromagnetic Compatibility", Oxford University Press, 1993.
- The European Standard EN 50289-1-6.

In order to make simplest and more reliable the transfer impedance measurement methods, several test benches have been proposed:

- US 4 425 542 Method and apparatus for measuring the surface transfer impedance of a piece of shielded cable
- US 4 931 720 Arrangement for measuring transfer impedances of coaxial cables
- FR 2 670 296 Test bench for cable transfer impedance measurement uses ribbon test conductor fixed under rigid plate accurately located over cable under test.

Nevertheless those improvements, some difficulties for the triaxial method as well as the line injection method are still present.
The result is that both the specific setting-up of the cable under test and the measurement procedure, required for the triaxial method (see EN 50289-1-6, § 6.2.4 fig. 11) and the line injection method (see EN 50289-1-6, § 7.2.4 fig. 16), are very time consuming.

In the triaxial test method one end of the cable under test must be matched with a well screened resistor and the second cable end is prepared with a connector to make the connection to the generator. The test sample shall be fitted to the test set-up. The test set-up is an apparatus having a conductive tube which forms a triple coaxial geometry together with the cable under test fitted in it. A second resistor has to be connected to the cable screen at the first end fitted in to the tube. The cable sheath has to be removed in the connector side and the screen has to be connected to the tube. Finally, different test set-up is required for different frequency measurement range.

In the line injection method the cable under test must be prepared connecting a first end to a matching resistor and the second cable end is prepared with a connector to make the connection to the receiver. Screened symmetrical cables and multi-conductor cable are treated connecting all pairs together at both ends as well as the screens shall be connected over the whole circumference. The calibration of the test set-up is required; the composite loss of the connecting cables and the injection circuit shall be measured and the calibration data has to be saved, so that the results may be corrected. Finally, because the cable screen can not be considered homogeneous, in the line injection method at least four measurements 90° apart shall be taken.

So, due to the increase in bandwidth demand and the more stringent requirements imposed by the electromagnetic compatibility (EMC) and the electromagnetic interference (EMI) standards, the investigation of the screening behavior of the screens of shielded cables becomes more and more important, as well as the need to have a more accurate and easy measuring method..

### Objects of the Invention

The main object of the present invention is to overcome the drawbacks of the known art introducing an easier and time saving method for evaluating the shielding effectiveness of the cables throughout the measurement of the transfer impedance ($Z_t$) and the transfer admittance ($Y_t$).

### Summary of invention

According to a first aspect of the invention, there is provided a method for measuring the transfer impedance ($Z_t$) and the transfer admittance ($Y_t$) of a shielded cable, having a previous defined length (L), as disclosed in claim 1.

According to second aspect of the invention, there is provided a test bench for supporting the method of claim 1, as disclosed in claim 8.

The proposed invention allows to achieve an accurate estimation of the actual values of Zt and Yt with only some voltage measurements on the load impedances, using a specific test bench arrangement and tuning the parameters of a proposed model accounting for the cable transfer impedance and admittance.

The injected currents on the external shield of the cable and the associated voltages between the shield and the reference plane give rise to a magnetic and electric coupling through the shield material (by diffusion) and its discontinuities (holes, apertures, etc. by radiation) inducing currents on the internal conductors and voltages between them and the shield.

These internally induced interferences can be seen as distributed equivalent sources whose final effects are undesired differences of potential across the load terminations of the conductors.

The coupling between the shield and the internal wires is described by the concepts of transfer impedance and transfer admittance.

The measurement method object of the invention is based on a circuit model for the evaluation of the voltages across the termination loads of the cables (e.g. coaxial and twin-ax), generated by a current injected on the external shield using, for example, an injecting clamp. The coupling between the shield current and the internal conductors is modeled by concentrating the distributed voltage and current sources in lumped voltage and current generators at one end of the line, considering the remaining part as a simple passive transmission line (TL).

This approach avoids the classic cable subdivision in multiple lumped element circuit cells and allows to evaluate the transfer impedance and admittance, tuning the proposed circuit model up to simulate the same voltages measured on the loads at each considered frequency.

### Brief description of the drawings.

Further advantages, characteristics and conditions of use will be apparent from the more particular description of exemplary embodiment, which is shown as an example but and without introducing any limitation, as illustrated in appended drawings, were:

**Figure 1** describes the transmission line (TL) model for the external shield;

**Figure 2** describes the multi-conductor transmission line (MTL) for a twinax cable formed by the two wires and the interior part of the shield; the twinax cable is represented by two uncoupled ideal TL and a set of voltage- and current-controlled sources forming two decoupling networks

**Figure 3** describes the equivalent circuit for evaluating $V_{FT,i\_Yt}$ (s) of a twinax cable using a standard circuit analyzer program such as SPICE (only 8 of the 17 terms in equation (10) are shown);

**Figure 4** describes the test bench arrangement.

## Detailed description of preferred embodiments of the invention

The embodiments illustrated in the figures and described hereafter, refer to a test bench arrangement and method for the transfer impedance (Zt) and the transfer admittance (Yt) of shielded twin-ax cable by the measurement of the voltages across the termination loads of the cables, generated by a current injected on the external shield using an injecting clamp.

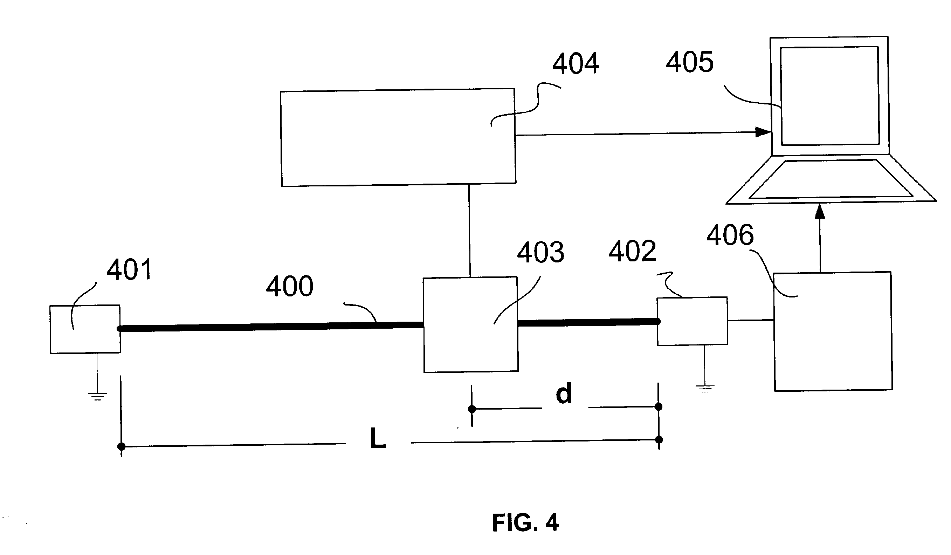

According to the attached figure 4, in which the test bench arrangement is depicted, the straight shielded cable (400) of length L is terminated with first matching impedance (401) at its first end and second matching impedance (402) at the second ends.

The matched impedances have to be connected among the inner conductors of the cable and the external shield.

A current injection clamp (403), such as the RF Current Clamp F-120-9A 10kHz...230MHz with Calibration Fixture FCC-BCICF-4 manufactured by FISCHER CUSTOM COMMUNICATIOS INC, is placed around the shielded cable (400). The injecting clamp (403), placed at a distance d from the first end of the cable, acts as a transformer inducing a known current $I_{SH}$ on the external part of the shield.

Such injection clamp is connected with devices (404) for measuring at each measurement frequency the $I_{SH}$ value. A suitable set of devices can be:

- *MARCONI INSTRUMENTS*
    - *9kHz - 2.4GHz signal generator 2024*
- *INSTRUMENTS FOR INDUSTRY, INC.*
    - *Power Supply / Control Module P.S. 5000/28/40*
    - *SMX 100 Wideband Amplifier 0.01 - 1000MHz*
- *ELECTRO-METRICS*
    - *Dual-directional coupler EM 7706A*
- *ROHDE & SCHWARZ*
    - *Power Sensor NRV-Z52 1μW... 100mW DC...26.5GHz 50Ω*
    - *FRW - S/N:846759/02*
    - *Power Meter NRVD Attenuator ESH2-Z11 0... 1.5GHz 10W 20dB*

Then, the $I_{SH}$ values are available for an automatic data processing device (405), such as a *Desktop Personal Computer* having installed a *standard circuit analyser program* such as *SPICE,* developed by the EECS Department of the University of California at Berkeley and downloadable free of charge via Web.

Device for voltage measurement (406), such as the *GIE 3030 Portable Spectrum Analyzer 100 kHz...3GHz* manufactured by *GIE GmbH,* have to be connected to the matched impedances at one of the two ends of the cable and voltage measurements **$V_{FT}$** have to be taken at each measurement frequency.

These **$V_{FT}$** voltage values are available for the automatic data processing device (405).

The length L of the cable and the distance d between the first end of the cable and the injecting clamp can be arbitrary.

The method for the evaluation of the Zt and Yt of a shielded cable, frequency by frequency, is based on the test bench arrangement previously described and on a model of the cable under test defined according with the theoretical approach described in the following paragraph in details.

The theoretical approach refers to the most general case of a shielded multi-conductor cable, modeled as an external transmission line (TL) having currents flowing on the exterior of the cable together with a ground plane return and an internal multi-conductor transmission line consisting of n internal conductors referenced to the interior part of the shield.

The model's equation (2) describes such internal multi-conductor transmission line, where the two lamped sources $V_{FT,i}$ and $I_{FT,i}$ for each i-th conductor placed at one end of the line are expressed according with the equations (6a) and (6b).

The results of such theoretical approach are the equations obtained, in a close form, for $V_{FT,i\_Zt}$ (s) and $V_{FT,i\_Yt}$

(s), $I_{FT,i\_Zt}$(s) and $I_{FT,i\_Yt}$ (s) as summation of several terms, and used for the evaluation of the Zt, and the Yt.

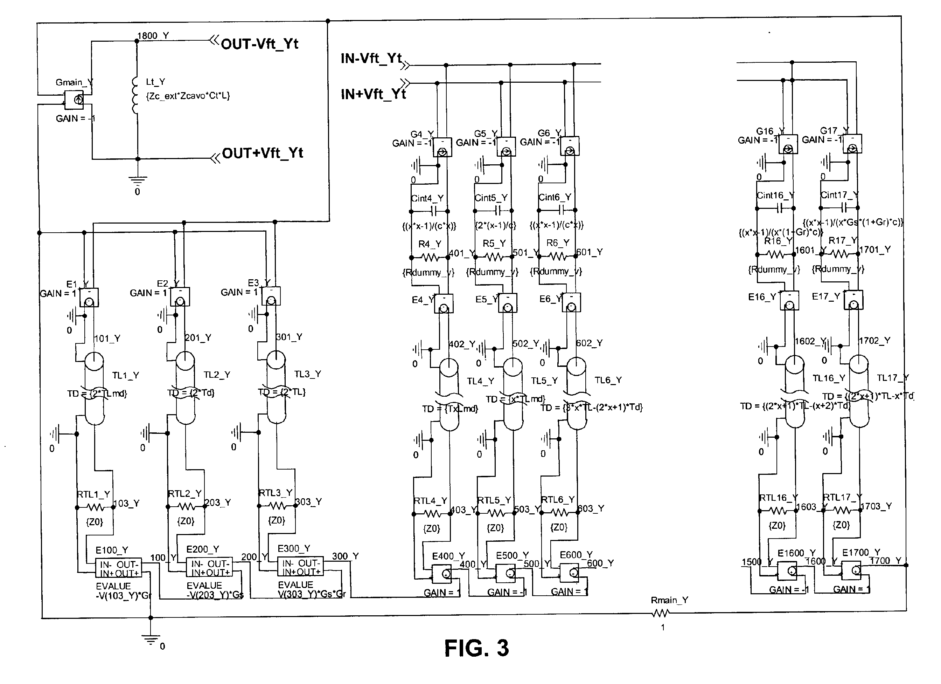

The equations used in the method, object of the invention, can be solved using a standard circuit analyzer program such as SPICE. In order to describe the preferred embodiment of the invention, the equivalent circuit for evaluating $V_{FT,i\_Yt}$ (s) of a twinax cable using a SPICE model is shown in the Fig.3.

The method for evaluating the transfer impedance and admittance of the shielded cable, frequency by frequency, is based on a procedure that comprises the following steps:

1) Modeling the cable according to the equations (2), (6a) and (6b), described in greater detail the following paragraph, and using a standard circuit analyzer program, such as SPICE, implemented in the automatic data processing device (405) to solve this equations by means of an equivalent circuit model of the cable; as an example, used to describe the preferred embodiment of the invention, the equivalent circuit used to solve the equation (10) for a twinax cable is described in the Fig.3.

2) Electrically terminating both the ends of the shielded cable by connecting a matching impedance (401; 402) between the shield and the inner conductor;

3) Placing the shielded cable in a current injection clamp (403) at a pre-defined distance (d) from the first end of the shielded cable;

4) Injecting on the cable shield, using the current injection clamp (403), a known current ($I_{SH}$) for all the defined frequency in the frequency measurement range, according with one among the standard procedures described in the documents:

   a. EN 61000-4-4 , Electrical fast transient/burst immunity test
   b. EN 61000-4-6, Immunity to conducted disturbances, inducted by radio frequency fields.
   c. RTCA, Environmental Conditions and Test Procedures for Airborne Equipments- Sect.22:Lighttning induced Transient Susceptibility.

5) Measuring the voltage ($V_{FT}$) between the first cable end of the inner conductors and the shield;

6) Transferring the current ($I_{SH}$) values and the voltage ($V_{FT}$) values to the automatic data processing device;

7) Simulating the cable by using the equivalent circuit model of the cable defined in the previous step 1);

8) Setting, in the equivalent circuit model of the cable (e.g.: Fig.3), Zt and Yt equal to the nominal values provided by the manufacturer or calculated , in an approximated way using the formulas well known to the technicians expert in the EMI field.

9) Setting, in the equivalent circuit model of the cable, the known current ($I_{SH}$) (e.g.: Fig.3 - between the nodes IN+Vft_Yt , IN-Vft_Yt and IN+Vft_Zt , IN-Vft_Zt);

10) If the simulated voltage at the measuring end of the inner conductors matches the measured voltage (within +/- an accepted error) the values of Zt and Yt previously introduced can be accepted as the best estimation.

11) If the simulated voltage at the measuring end of the inner conductors doesn't match the measured voltage (outside +/- an accepted error), the values of Zt and/or Yt must be adjusted of a quantity defined according to the adopted iterative computation method, and the simulation must be repeated.

12) Return to step 10)

**Theoretical approach used to describe the model of a shielded multi-conductor cable**

The method for the evaluation of the Zt and Yt of a shielded cable relies on a simplified model of the cable.

The problem is formulated by considering an external transmission line (TL) having currents flowing on the exterior of the cable together with a ground plane return and an internal multi-conductor transmission line consisting of n internal conductors referenced to the interior part of the shield. The coupling between the external and internal TLs is operated by the transfer impedances and admittances.

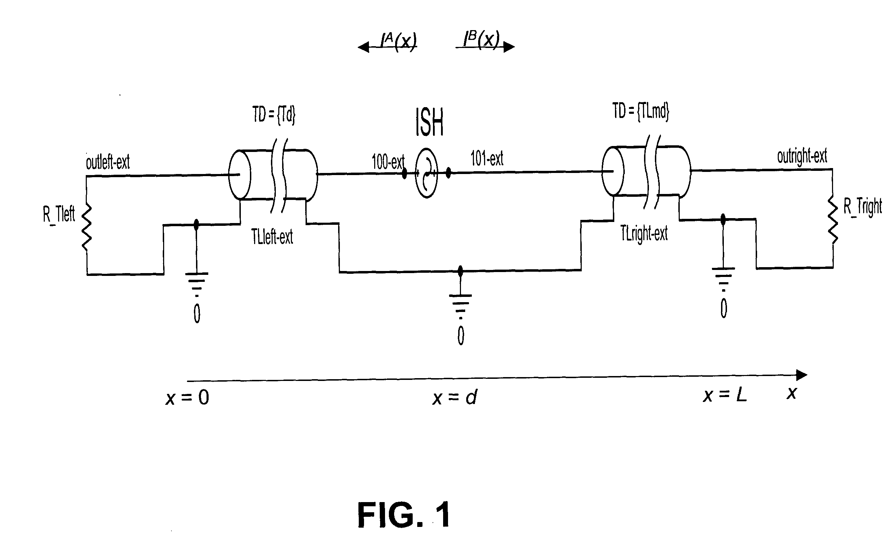

**The external shield** is modelled by means of a TL as shown in Fig. 1: the injecting clamp (403), placed at a distance d from the axis origin x = 0, acts on the external part of the shield as a transformer inducing a known current $I_{SH}$. The expressions of the spatial distribution of the propagating currents $I^A(x)$ and $I^B(x)$ on the outer surface of the shield and the associated voltages $V^A(x)$ and $V^B$ (x) are

$$I^A(x) = -\frac{I_{SH}e^{-j\beta_0(d-x)}}{1-\Gamma_S e^{-j2\beta_0 d}}\left[1 - \Gamma_S e^{-j2\beta_0 x}\right] \quad for \quad 0 \le x \le d$$

$$(1a)$$

$$V^A(x) = Z_0 \frac{I_{SH} e^{-j\beta_0(d-x)}}{1 - \Gamma_S e^{-j2\beta_0 d}} \left[1 + \Gamma_S e^{-j2\beta_0 x}\right] \quad for \quad 0 \le x \le d$$

(1b)

$$I^B(x) = -\frac{I_{SH} e^{-j\beta_0(x-d)}}{1 - \Gamma_R e^{-j2\beta_0(L-d)}} \left[1 - \Gamma_R e^{-j2\beta_0(L-x)}\right] \quad for \quad d \le x \le L$$

(1c)

$$V^B(x) = -Z_0 \frac{I_{SH} e^{-j\beta_0(x-d)}}{1 - \Gamma_R e^{-j2\beta_0(L-d)}} \left[1 + \Gamma_R e^{-j2\beta_0(L-x)}\right] \quad for \quad d \le x \le L$$

(1d)

In (1) $\beta_0$ is the propagation constant of the external TL

$$\beta_0 = \frac{2\pi f}{c},$$

f is the frequency, c is the speed of light in free space, $Z_0$ is the characteristic impedance of the external TL and $\Gamma_S$ and $\Gamma_R$ are the reflection coefficients looking into the left (x = 0) and right (x = L) terminations respectively.

**The internal TL** is given by the n coupled parallel conductors and the internal surface of the shield. The model's equations (bold letters indicate vectors or matrices) are

$$\begin{bmatrix} \mathbf{V}(L) \\ \mathbf{I}(L) \end{bmatrix} = \Phi(L) \begin{bmatrix} \mathbf{V}(0) \\ \mathbf{I}(0) \end{bmatrix} + \int_0^L \Phi(L-\tau) \begin{bmatrix} \mathbf{V}_S(\tau) \\ \mathbf{I}_S(\tau) \end{bmatrix} d\tau = \Phi(L) \begin{bmatrix} \mathbf{V}(0) \\ \mathbf{I}(0) \end{bmatrix} + \begin{bmatrix} \mathbf{V}_{FT} \\ \mathbf{I}_{FT} \end{bmatrix}$$

(2)

where

$\mathbf{V}(x) = [V_1(x) \cdots V_n(x)]^t$

$\mathbf{I}(x) = [I_1(x) \cdots I_n(x)]^t$

(t apex means transposition) are the voltages with respect the internal shield and the currents of the n internal conductors respectively, $\Phi(L)$ is the 2n x 2n chain parameter matrix

$$\Phi(L) = \begin{bmatrix} \Phi_{11}(L) & \Phi_{12}(L) \\ \Phi_{21}(L) & \Phi_{22}(L) \end{bmatrix}.$$

(3)

and

$$\mathbf{V}_S(\tau) = \mathbf{Z}_t \mathbf{I}_{ext}(\tau) = \begin{bmatrix} Z_t^1 & \cdots & Z_t^n \end{bmatrix} \mathbf{I}_{ext}(\tau)$$

(4a)

$$\mathbf{I}_S(\tau) = \mathbf{Y}_t \mathbf{V}_{ext}(\tau) = \begin{bmatrix} Y_t^1 & \cdots & Y_t^n \end{bmatrix} \mathbf{V}_{ext}(\tau) \qquad (4b)$$

where

$$\mathbf{I}_{ext}(\tau) = \begin{cases} I^A(\tau)\mathbf{1}_{nx1} = \mathbf{I}^A \text{ for } 0 \le \tau \le d \\ I^B(\tau)\mathbf{1}_{nx1} = \mathbf{I}^B \text{ for } d \le \tau \le L \end{cases} \qquad (5a)$$

$$\mathbf{V}_{ext}(\tau) = \begin{cases} V^A(\tau)\mathbf{1}_{nx1} = \mathbf{V}^A \text{ for } 0 \le \tau \le d \\ V^B(\tau)\mathbf{1}_{nx1} = \mathbf{V}^B \text{ for } d \le \tau \le L \end{cases} \qquad (5b)$$

in which $\mathbf{1}_{nx1}$ is the unit matrix of dimensions n x 1. Taking into account (4), the vectors $\mathbf{V}_{FT} = [V_{FT,1} \cdots V_{FT,n}]^t$ and $\mathbf{I}_{FT} = [I_{FT,1} \cdots I_{FT,n}]^t$ in the right hand side (RHS) of (2) are expressed as

$$\mathbf{V}_{FT} = \mathbf{V}_{FT\_Zt} + \mathbf{V}_{FT\_Yt} = \int_0^L \mathbf{\Phi}_{11}(L-\tau)\mathbf{Z}_t\mathbf{I}_{ext}(\tau)d\tau + \int_0^L \mathbf{\Phi}_{12}(L-\tau)\mathbf{Y}_t\mathbf{V}_{ext}(\tau)d\tau \qquad (6a)$$

$$\mathbf{I}_{FT} = \mathbf{I}_{FT\_Zt} + \mathbf{I}_{FT\_Yt} = \int_0^L \mathbf{\Phi}_{21}(L-\tau)\mathbf{Z}_t\mathbf{I}_{ext}(\tau)d\tau + \int_0^L \mathbf{\Phi}_{22}(L-\tau)\mathbf{Y}_t\mathbf{V}_{ext}(\tau)d\tau \qquad (6b)$$

The circuit interpretation of (2) and (6) is that of a passive MTL having the properties of the interior cable (length L, number of conductors, etc.) with two lumped sources $V_{FT,i}$ and $I_{FT,i}$ for each i-th conductor placed at one end of the line. These sources take into account the inducing effects of the external current and voltage due to the cable's $\mathbf{Z}_t$ and $\mathbf{Y}_t$. The MTL is completed by terminations networks connecting the internal conductors among them and with the shield. In the following section full Spice circuits are developed for the evaluation, in frequency and time domain, of (2) and (6) for twinax cables.

**A twinax cable** is formed by an external shield that contains n = 2 parallel wires embedded in a dielectric material. Let's assume that the dielectric is homogeneous, lossless and that the wires are perfectly conductive. Under these assumptions the entries in (3) at a generic abscissa x are:

$$\Phi_{11}(x) = \Phi_{22}(x) = \cos(\beta x)\mathbf{1}_{nxn} \qquad (7a);$$

$$\Phi_{12}(x) = -jv\sin(\beta x)\mathbf{L} \qquad (7b);$$

$$\Phi_{21}(x) = -jv\sin(\beta x)\mathbf{C} \qquad (7b)$$

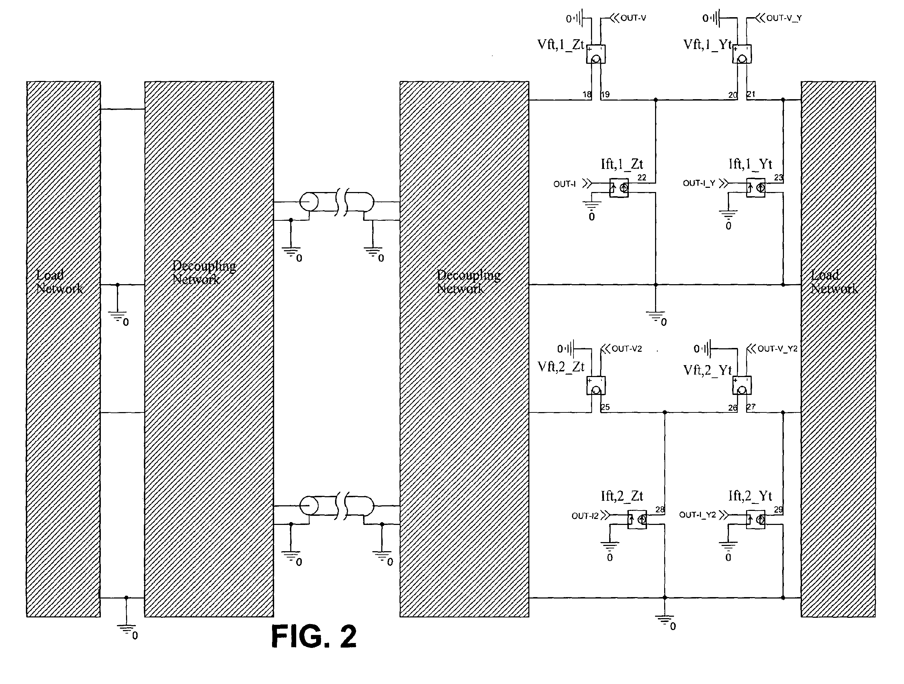

where $j = \sqrt{-1}$, $\mathbf{L}$ and $\mathbf{C}$ are the p.u.l. inductance and capacitance matrices whose entries are $l_{ij}$ and $c_{ij}$ respectively, v is the propagation velocity and $\beta$ the propagation constant in the dielectric. By applying the modal decoupling procedure as in the literature, the MTL formed by the two wires and the interior part of the shield can be represented by two uncoupled ideal TL and a set of voltage-and current-controlled sources forming two decoupling networks as shown in Fig. 2. In this figure the symbols of the circuit elements are those proper of the Spice syntax. After having represented the passive part of the internal MTL one needs to develop the equivalent circuits for the source terms $\mathbf{V}_{FT}$ and $\mathbf{I}_{FT}$.

For a twinax cable the source terms in (6) have only two entries

$$\mathbf{V}_{FT} = \begin{bmatrix} V_{FT,1} & V_{FT,2} \end{bmatrix}^t$$

$$\mathbf{I}_{FT} = \begin{bmatrix} I_{FT,1} & I_{FT,2} \end{bmatrix}^t .$$

The general expression for the i-th entry is

$$V_{FT,i} = V_{FT,i\_Zt} + V_{FT,i\_Yt} = \left\{ \int_0^d \cos(\beta(L-\tau))Z_t^i I^A(\tau)d\tau + \int_d^L \cos(\beta(L-\tau))Z_t^i I^B(\tau)d\tau \right\} - $$
$$\left\{ \int_0^d j\sin(\beta(L-\tau))Z_c^i Y_t^i V^A(\tau)d\tau + \int_d^L j\sin(\beta(L-\tau))Z_c^i Y_t^i V^B(\tau)d\tau \right\}$$

$$(8a)$$

$$I_{FT,i} = I_{FT,i\_Yt} + I_{FT,i\_Zt} = \left\{ \int_0^d \cos(\beta(L-\tau))Y_t^i V^A(\tau)d\tau + \int_d^L \cos(\beta(L-\tau))Y_t^i V^B(\tau)d\tau \right\} - $$
$$\left\{ \int_0^d j\sin(\beta(L-\tau))Y_c^i Z_t^i I^A(\tau)d\tau + \int_d^L j\sin(\beta(L-\tau))Y_c^i Z_t^i I^B(\tau)d\tau \right\}$$

$$(8b)$$

in which

$$Z_c^i = \begin{cases} v(l_{11}+l_{12}) \; for \; i=1 \\ v(l_{21}+l_{22}) \; for \; i=2 \end{cases}$$

$$Y_c^i = \begin{cases} v(c_{11}+c_{12}) \; for \; i=1 \\ v(c_{21}+c_{22}) \; for \; i=2 \end{cases} .$$

In (8) there are in evidence the terms depending on the transfer impedance and admittance. Due to the strong symmetries in these equations, for sake of brevity in the following the focus will be on the analytical integration and development of equivalent circuits only for $V_{FT,i}$ showing how the $I_{FT,i}$ terms can be easily treated by the same procedure.

Rewriting (8a) in Laplace domain with s = jω, substituting (1) into it and considering the exponential form of (7) for lossless line, the integration can be performed and a closed form is obtained for $V_{FT,\,i\_Zt}$ (s) and $V_{FT,i\_Yt}$ (s), as summation of several terms.

For $V_{FT,i\_Zt}$ (s) one has

$$V_{FT,i\_Zt}(s)e^{-s\left[2\sqrt{\varepsilon_r}T_L-\left(\sqrt{\varepsilon_r}+1\right)T_d\right]} = V_{FT,i\_Zt}(s)\Gamma_R e^{-s[2T_{Lmd}]} + V_{FT,i\_Zt}(s)\Gamma_S e^{-s[2T_d]} +$$

$$-V_{FT,i\_Zt}(s)\Gamma_S\Gamma_R e^{-s[2T_L]} + Z_t^i\Big[\ \frac{c}{\varepsilon_r-1}e^{-sT\sqrt{\varepsilon_r}Lmd}\frac{1}{s}I_{SH}(s) - \frac{c}{2(\sqrt{\varepsilon_r}-1)}e^{-s\sqrt{\varepsilon_r}T_{Lmd}}\frac{1}{s}I_{SH}(s) +$$

$$+\frac{c}{\varepsilon_r-1}e^{-s\left[3\sqrt{\varepsilon_r}T_L-\left(2\sqrt{\varepsilon_r}+1\right)T_d\right]}\frac{1}{s}I_{SH}(s) + \frac{c}{2(\sqrt{\varepsilon_r}+1)}e^{-s\sqrt{\varepsilon_r}T_{3Lmd}}\frac{1}{s}I_{SH}(s) +$$

$$\frac{\Gamma_S c}{2(\sqrt{\varepsilon_r}+1)}e^{-s\sqrt{\varepsilon_r}T_{Lmd}}\frac{1}{s}I_{SH}(s) + -\frac{\Gamma_S c}{2(\sqrt{\varepsilon_r}-1)}e^{-s\sqrt{\varepsilon_r}T_{3Lmd}}\frac{1}{s}I_{SH}(s) +$$

$$\frac{\Gamma_R c}{2\sqrt{\varepsilon_r}-1}e^{-s\left(2+\sqrt{\varepsilon_r}\right)T_{Lmd}}\frac{1}{s}I_{SH}(s) - \frac{\Gamma_R c}{2(\sqrt{\varepsilon_r}+1)}e^{-s\left[\left(3\sqrt{\varepsilon_r}+2\right)T_L-\left(\sqrt{\varepsilon_r}+2\right)T_d\right]}\frac{1}{s}I_{SH}(s)$$

$$-\frac{\Gamma_S\Gamma_R c}{\varepsilon_r-1}e^{-s\left[\left(2+\sqrt{\varepsilon_r}\right)T_L-T_d\right]}\frac{1}{s}I_{SH}(s) - \frac{\Gamma_S\Gamma_R c}{2(\sqrt{\varepsilon_r}+1)}e^{-s\left(2+\sqrt{\varepsilon_r}\right)T_{Lmd}}\frac{1}{s}I_{SH}(s)$$

$$-\frac{\Gamma_S\Gamma_R c}{\varepsilon_r-1}e^{-s\left[\left(3\sqrt{\varepsilon_r}+2\right)T_L-\left(2\sqrt{\varepsilon_r}+1\right)T_d\right]}\frac{1}{s}I_{SH}(s) + \frac{\Gamma_S\Gamma_R c}{2(\sqrt{\varepsilon_r}-1)}e^{-s\left[\left(3\sqrt{\varepsilon_r}+2\right)T_L-\left(\sqrt{\varepsilon_r}+2\right)T_d\right]}\frac{1}{s}I_{SH}(s)$$

$$-\frac{(1+\Gamma_R)c}{\varepsilon_r-1}e^{-s\left[2\left(\sqrt{\varepsilon_r}+1\right)T_L-\left(\sqrt{\varepsilon_r}+2\right)T_d\right]}\frac{1}{s}I(s) + +\frac{\Gamma_S(1+\Gamma_R)c}{\varepsilon_r-1}e^{-s\left[\left(2\sqrt{\varepsilon_r}+1\right)T_L-\sqrt{\varepsilon_r}T_d\right]}\frac{1}{s}I_{SH}(s)\ \Big] \tag{9}$$

and for $V_{FT,i\_Yt}(s)$

$$V_{FT,i\_Yt}(s)e^{-s\left[2\sqrt{\varepsilon_r}T_L-\left(\sqrt{\varepsilon_r}+1\right)T_d\right]} = V_{FT,i\_Yt}(s)\Gamma_R e^{-s[2T_{Lmd}]} + V_{FT,i\_Yt}(s)\Gamma_S e^{-s[2T_d]} +$$

$$-V_{FT,i\_Yt}(s)\Gamma_S\Gamma_R e^{-s[2T_L]} + Z_0 Z_c^i Y_t^i\Big[\ \frac{\sqrt{\varepsilon_r}c}{\varepsilon_r-1}e^{-sT\sqrt{\varepsilon_r}Lmd}\frac{1}{s}I_{SH}(s)$$

$$-\frac{c}{2(\sqrt{\varepsilon_r}-1)}e^{-s\sqrt{\varepsilon_r}T_{Lmd}}\frac{1}{s}I_{SH}(s) + +\frac{\sqrt{\varepsilon_r}c}{\varepsilon_r-1}e^{-s\left[3\sqrt{\varepsilon_r}T_L-\left(2\sqrt{\varepsilon_r}+1\right)T_d\right]}\frac{1}{s}I_{SH}(s)$$

$$-\frac{c}{2(\sqrt{\varepsilon_r}+1)}e^{-s\sqrt{\varepsilon_r}T_{3Lmd}}\frac{1}{s}I_{SH}(s) - \frac{\Gamma_S c}{2(\sqrt{\varepsilon_r}+1)}e^{-s\sqrt{\varepsilon_r}T_{Lmd}}\frac{1}{s}I_{SH}(s) +$$

$$-\frac{\Gamma_S c}{2(\sqrt{\varepsilon_r}-1)}e^{-s\sqrt{\varepsilon_r}T_{3Lmd}}\frac{1}{s}I_{SH}(s) + \frac{\Gamma_R c}{2(\sqrt{\varepsilon_r}-1)}e^{-s\left(2+\sqrt{\varepsilon_r}\right)T_{Lmd}}\frac{1}{s}I_{SH}(s)$$

$$+ \frac{\Gamma_R c}{2(\sqrt{\varepsilon_r}+1)} e^{-s\left[\left(3\sqrt{\varepsilon_r}+2\right)T_L - \left(\sqrt{\varepsilon_r}+2\right)T_d\right]} \frac{1}{s} I_{SH}(s) - \frac{\sqrt{\varepsilon_r}\Gamma_S\Gamma_R c}{\varepsilon_r - 1} e^{-s\left[\left(2+\sqrt{\varepsilon_r}\right)T_L - T_d\right]} \frac{1}{s} I_{SH}(s)$$

$$+ \frac{\Gamma_S\Gamma_R c}{2(\sqrt{\varepsilon_r}+1)} e^{-s\left(2+\sqrt{\varepsilon_r}\right)T_{Lmd}} \frac{1}{s} I_{SH}(s) - \frac{\sqrt{\varepsilon_r}\Gamma_S\Gamma_R c}{\varepsilon_r - 1} e^{-s\left[\left(3\sqrt{\varepsilon_r}+2\right)T_L - \left(2\sqrt{\varepsilon_r}+1\right)T_d\right]} \frac{1}{s} I_{SH}(s)$$

$$+ \frac{\Gamma_S\Gamma_R c}{2(\sqrt{\varepsilon_r}-1)} e^{-s\left[\left(3\sqrt{\varepsilon_r}+2\right)T_L - \left(\sqrt{\varepsilon_r}+2\right)T_d\right]} \frac{1}{s} I_{SH}(s) - \frac{\sqrt{\varepsilon_r}(1+\Gamma_R)c}{\varepsilon_r - 1} e^{-s\left[2\left(\sqrt{\varepsilon_r}+1\right)T_L - \left(\sqrt{\varepsilon_r}+2\right)T_d\right]} \frac{1}{s} I(s) +$$

$$+ \frac{\sqrt{\varepsilon_r}\Gamma_S(1+\Gamma_R)c}{\varepsilon_r - 1} e^{-s\left[\left(2\sqrt{\varepsilon_r}+1\right)T_L - \sqrt{\varepsilon_r}T_d\right]} \frac{1}{s} I_{SH}(s) \; \bigg]$$

$$(10)$$

In (9) and (10) $\varepsilon_r$ is the relative electric permittivity of the dielectric filling and

$$T_L = \frac{L}{c} \tag{11a}$$

$$T_d = \frac{d}{c} \tag{11b}$$

$$T_{Lmd} = \frac{L\text{-}d}{c} \tag{11c}$$

$$T_{2Lmd} = \frac{2L\text{-}d}{c} \tag{11d}$$

$$T_{3Lmd} = \frac{3L\text{-}d}{c} \tag{11e}$$

$$T_{\sqrt{\varepsilon_r}Lmd} = \frac{\sqrt{\varepsilon_r}L\text{-}d}{c} \tag{11f}$$

Equations (9) and (10) are retarded by a common operator

$$e^{-s\left(2\sqrt{\varepsilon_r}T_L - \left(\sqrt{\varepsilon_r}+1\right)T_d\right)} = e^{-sT_1}$$

in order to eliminate eventual advancing time operators $e^{+sT}$ that can appear during the integration. The time delay $T_1$ is the same for $V_{FT,i\_Zt}(s)$ and $V_{FT,i\_Yt}(s)$ but also for $I_{FT,i\_Zt}(s)$ and $I_{FT,i\_Yt}(s)$ for any i. Any addend of the RHS of (10) (and equally for (9) ) consists on a constant, a retardation operator $e^{-sT}$ and an integration operator $\frac{1}{s}$ applied to a known voltage or current. Each term can be make equal to a voltage on which an ideal TL operates a retardation, a capacitor operates the integration and suitable voltage and current controlled generators take into account the multiplication constants.

The output of each addend is in the form of a controlled voltage source that, connected in series with all the others, gives the total $V_{FT,i\_Zt}(s)$ and $V_{FT,i\_Yt}(s)$. Fig. 3 shows the equivalent circuit for $V_{FT,i\_Yt}(s)$ in (10) in which the values of the lumped elements change depending if i = 1 or 2. The impressed current $I_{SH}$, probed by the equivalent circuit of the external problem in Fig. 1, is injected between the nodes IN+Vft_Yt and IN-Vft_Yt,( ci vuole un punto?) Rdummy are(is?) the dummy resistance(s) required by the Spice syntax to avoid floating nodes, Gs and Es are voltage-controlled current and voltage sources respectively.

This circuit is the implementation of (10) that, in turn, is the exact solution of the transfer admittance contribution in (8a) delayed by $T_1$ seconds.

The voltage across the external nodes OUT+Vft_Yt and OUT-Vft_Yt is the sought $V_{FT,i\_Yt}(s)$. The same considerations hold (apply) for the controlled voltage source term $V_{FT,i\_Zt}(s)$ relative to the transfer impedance in (9).

It is worthy noting that:

a) the topology of the equivalent circuit is the same for all the eight terms $V_{FT,i\_Zt}(s)$, $V_{FT,i\_Yt}(s)$, $I_{FT,i\_Zt}(s)$ and $I_{FT,i\_Yt}(s)$ (i = 1,2): only the values of the circuit parameters change;

b) because all the eight terms are delayed/(or shifted) (retarded refers to mental disease )by the same quantity $T_1$ the analysis of the circuit in Fig. 2 is not affected by this delay and the final results will be simply shifted by $T_1$;

c) the equivalent circuits in Fig. 1, 2 and 3 - although developed in Laplace domain - are ready to be used also for a transient analysis: this allows one to readily incorporate non-linear terminations at the ends of the cable.

**Claims**

1. A method for measuring the transfer impedance ($Z_t$) and the transfer admittance ($Y_t$) of a shielded cable (5), having a previous defined length (L), **characterized in that** includes the steps of:

   a) modeling the cable according to predefined equations using a standard circuit analyzer program, implemented in an automatic data processing device (405) to solve said predefined equations by means of an equivalent circuit model of the cable;
   b) evaluating the voltages across the termination loads of the cables generated by a current injected on the external shield;
   c) modeling the coupling between the shield current and the internal conductors by concentrating the distributed voltage and current sources in lumped voltage and current generators at one end of the line;
   d) considering, in the course of said coupling modeling, the remaining part of the cable as a simple passive transmission line (TL).

2. The method of claim 1, **characterized in that** said modeling step a) is performed according to the equations (2):

$$\begin{bmatrix} \mathbf{V}(L) \\ \mathbf{I}(L) \end{bmatrix} = \Phi(L)\begin{bmatrix} \mathbf{V}(0) \\ \mathbf{I}(0) \end{bmatrix} + \int_0^L \Phi(L-\tau)\begin{bmatrix} \mathbf{V}_S(\tau) \\ \mathbf{I}_S(\tau) \end{bmatrix} d\tau = \Phi(L)\begin{bmatrix} \mathbf{V}(0) \\ \mathbf{I}(0) \end{bmatrix} + \begin{bmatrix} \mathbf{V}_{FT} \\ \mathbf{I}_{FT} \end{bmatrix}$$

where:

- $\mathbf{V}(x)$ and $\mathbf{I}(x)$, where $0 < x < L$, are the voltages with respect the internal shield and the currents of the n internal conductors respectively;
- $\Phi(L)$ is the 2n x 2n chain parameter matrix;
- $\mathbf{V}_S(\tau)$ and $\mathbf{I}_S(\tau)$ are the voltage and the current induced in the internal conductors due to the current on the shielded cable;
- $\mathbf{V}_{FT}$ and $\mathbf{I}_{FT}$ are the voltage and current lumped source matrix

3. The method of claim 1, **characterized in that** said evaluating step b) includes the sub-steps of;

   - Electrically terminating both ends of the shielded cable by connecting a matching impedance (401; 402) between the shield and the inner conductor;
   - Placing the shielded cable in a current injection clamp (403) at a pre-defined distance (d) from the first end of the shielded cable;
   - Injecting on the cable shield, using the current injection clamp (403), a known current $\mathbf{I}_{SH}$ for all the defined frequency in the frequency measurement range;
   - Measuring the voltage $\mathbf{V}_{FT}$ between the first cable end of the inner conductors and the shield;
   - Transferring the current $\mathbf{I}_{SH}$ values and the voltage $\mathbf{V}_{FT}$ values to the automatic data processing device;

4. The method of claim 1, **characterized in that** said modeling step c) includes the sub steps of:

   - Simulating the cable by using the equivalent circuit model of the cable defined in the previous step a);

- Setting, in the equivalent circuit model of the cable, a first approximate value of Zt and Yt;
- Setting, in the equivalent circuit model of the cable, the current value **I$_{SH}$**;
- If the simulated voltage at the measuring end of the inner conductors matches the measured voltage, within a defined tolerance, the previous values of Zt and Yt can be accepted as their best estimation
- If the simulated voltage at the measuring end of the inner conductors doesn't match the measured voltage, outside a defined tolerance, the values of Zt and Yt must be adjusted according to the adopted iterative computation method, and the simulations must be repeated
- Return to the last but one step.

5. The method of the previous claims, **characterized in that** the shielded cable is supported in a rectilinear position and having the same axis of the current injection clamp (403).

6. The method of the previous claims, **characterized in that** the shielded cable is of coaxial cables type.

7. The method of the previous claims, **characterized in that** the shielded cable is of multiple conductor cables type.

8. Test bench arrangement for measuring the transfer impedance ($Z_t$) and the transfer admittance ($Y_t$) of a shielded cable (5), having a previous defined length (L), **characterized in that** includes the following elements:

- a first matching impedance (401) at the first end of said shielded cable (5) connected among the inner conductors of the cable and the external shield;
- a second matching impedance (402) at the second ends of said shielded cable (5) connected among the inner conductors of the cable and the external shield;
- a current injection clamp (403), placed around the shielded cable (400), placed at a distance d from the first end of the cable and inducing a known current I$_{SH}$ on the external part of the shield;
- a devices (404) for measuring at each measurement frequency the I$_{SH}$ value connected to said injection clamp.
- an automatic data processing device (405), such as a *Desktop Personal Computer* having installed a standard circuit analyser program,adapted to receive said I$_{SH}$ values;
- a device for voltage measurement (406), connected to the matched impedances at one of the two ends of the cable and to said automatic data processing device (405).

9. The test bench of claim 1, **characterized in that** said standard circuit analyzer program is the program known as *SPICE* .

10. The test bench of claim 1, **characterized in that** includes means adapted to support the cable in a rectilinear position and having the same axis of the current injection clamp (403).

**FIG. 1**

**FIG. 2**

OUT-Vft_Yt

IN-Vft_Yt

IN+Vft_Yt

1800_Y

Gmain_Y

Lt_Y
{Zc_ext*Zcavo*Ct*L}

GAIN = -1

OUT+Vft_Yt

0

G4_Y
GAIN = -1

G5_Y
GAIN = -1

G6_Y
GAIN = -1

G16_Y
GAIN = -1

G17_Y
GAIN = -1

0

Cint4_Y

Cint5_Y

Cint6_Y

Cint16_Y

Cint17_Y

$\{(x*x-1)/(c*x)\}$

$\{2*(x-1)/c\}$

$\{(x*x-1)/(c*x)\}$

$\{(x*x-1)/(x*(1-Gr)*c)\}$

$\{(x*x-1)/(x*Gs*(1+Gr)*c)\}$

R4_Y

R5_Y

R6_Y

R16_Y

R17_Y

401_Y

501_Y

601_Y

1601_Y

1701_Y

{Rdummy_y}

{Rdummy_y}

{Rdummy_y}

{Rdummy_y}

{Rdummy_y}

E1_Y
GAIN = 1

E2_Y
GAIN = 1

E3_Y
GAIN = 1

E4_Y

E5_Y

E6_Y

E16_Y

E17_Y

101_Y

201_Y

301_Y

402_Y

502_Y

602_Y

1602_Y

1702_Y

0

TL1_Y

TL2_Y

TL3_Y

TL4_Y

TL5_Y

TL6_Y

TL16_Y

TL17_Y

TD = {2*TLmd}

TD = {2*Td}

TD = {2*TL}

TD = {Tx*Lmd}

TD = {8*x*TL-(2*x+1)*Td}

TD = {(2*x+1)*TL-(x+2)*Td}

TD = {(2*x+1)*TL-x*Td}

0

RTL1_Y

RTL2_Y

RTL3_Y

RTL4_Y

RTL5_Y

RTL6_Y

RTL16_Y

RTL17_Y

103_Y

203_Y

303_Y

403_Y

503_Y

603_Y

1603_Y

1703_Y

{Z0}

{Z0}

{Z0}

{Z0}

{Z0}

{Z0}

{Z0}

{Z0}

E100_Y

E200_Y

E300_Y

E400_Y

E500_Y

E600_Y

E1600_Y

E1700_Y

IN- OUT-
IN+ OUT+

100_Y

200_Y

300_Y

400_Y

500_Y

600_Y

1500_Y

1600_Y

1700_Y

EVALUE
-V(103_Y)*Gr

EVALUE
-V(203_Y)*Gs

EVALUE
V(303_Y)*Gs*Gr

GAIN = 1

GAIN = -1

GAIN = 1

GAIN = -1

GAIN = 1

Rmain_Y

1

0

**FIG. 3**

EP 1 519 198 A1

**FIG. 4**

EP 1 519 198 A1

**European Patent Office**

**EUROPEAN SEARCH REPORT**

Application Number

EP 03 42 5631

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | ORLANDI A: "Frequency- and time-domain modeling of the transfer impedance and distributed longitudinal induced voltage by means of a SPICE equivalent circuit" IEEE TRANSACTIONS ON ELECTROMAGNETIC COMPATIBILITY, FEB. 2003, IEEE, USA, vol. 45, no. 1, pages 125-129, XP002271996 ISSN: 0018-9375 * the whole document * --- | 1-10 | G01R31/02 |
| X | S.CANIGGIA, L.VITUCCI,M.ACQUAROLI, A:GIORDANO: "Measurements and spice model for data signal lines under electrical fast-transient test" CONF PROC INT SYMP ELECTROMAGNETIC COMPATIBILITY EMC EUROPE, vol. 1, September 2000 (2000-09), pages 357-362, XP008027843 * the whole document * --- | 1-10 | |
| A | PAUL C R: "Solution of the transmission-line equations under the weak-coupling assumption" IEEE TRANSACTIONS ON ELECTROMAGNETIC COMPATIBILITY, AUG. 2002, IEEE, USA, vol. 44, no. 3, pages 413-423, XP002271998 ISSN: 0018-9375 * paragraph [0004] * --- | 1-10 | TECHNICAL FIELDS SEARCHED (Int.Cl.7)<br><br>G01R |
| D,A | FR 2 670 296 A (AXON CABLE SA) 12 June 1992 (1992-06-12) * abstract; claim 1; figures 1,2 * --- | 1-10 | |
| | -/-- | | |

The present search report has been drawn up for all claims

| Place of search | Date of completion of the search | Examiner |
|---|---|---|
| BERLIN | 3 March 2004 | Binger, B |

EPO FORM 1503 03.82 (P04C01)

European Patent
Office

**EUROPEAN SEARCH REPORT**

Application Number

EP 03 42 5631

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| T | ORLANDI A: "Full SPICE model for transfer impedance and transfer admittance inclusion in shielded coaxial cables analysis" IEE PROCEEDINGS-SCIENCE, MEASUREMENT AND TECHNOLOGY, 3 NOV. 2003, IEE, UK, vol. 150, no. 6, pages 297-306, XP002271997 ISSN: 1350-2344 * the whole document * | 1-10 | |
| | ----- | | |

TECHNICAL FIELDS
SEARCHED (Int.Cl.7)

The present search report has been drawn up for all claims

| Place of search | Date of completion of the search | Examiner |
|---|---|---|
| BERLIN | 3 March 2004 | Binger, B |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

    ..................................................................

& : member of the same patent family, corresponding
    document

EPO FORM 1503 03.82 (P04C01)

**EP 1 519 198 A1**

## ANNEX TO THE EUROPEAN SEARCH REPORT
## ON EUROPEAN PATENT APPLICATION NO.

EP 03 42 5631

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2004

| Patent document cited in search report | | Publication date | Patent family member(s) | | Publication date |
|---|---|---|---|---|---|
| FR 2670296 | A | 12-06-1992 | FR | 2670296 A1 | 12-06-1992 |

EPO FORM P0459

For more details about this annex : see Official Journal of the European Patent Office, No. 12/82

19